# EUROPÄISCHE PATENTSCHRIFT

(11) **EP 3 685 429 B1**
(45) Veröffentlichungstag und Bekanntmachung des Hinweises auf die Patenterteilung: **27.10.2021**
(21) Anmeldenummer: 18768799.1
(22) Anmeldetag: 31.08.2018
(51) Int. Cl.: H01L 21/67, H01L 21/683, H05K 13/08, H05K 13/04, B65G 47/91, H05K 13/02, B65G 47/84

(54) **VORRICHTUNG ZUR AUSRICHTUNG UND OPTISCHEN INSPEKTION EINES HALBLEITERBAUTEILS**
DEVICE FOR ALIGNMENT AND OPTICAL INSPECTION OF A SEMICONDUCTOR DEVICE
DISPOSITIF POUR L'ALIGNEMENT ET L'INSPECTION OPTIQUE D'UN COMPOSANT SEMICONDUCTEUR

(30) Priorität: 21.09.2017 DE 102017008869
(43) Veröffentlichungstag der Anmeldung: 29.07.2020
(73) Patentinhaber: Muehlbauer GmbH & Co. KG, 93426 Roding (DE)
(72) Erfinder: AUGST, Franz Uwe, 92442 Wackersdorf (DE); HOLZNER, Benjamin, 92526 Oberviechtach (DE)
(74) Vertreter: Schmidt, Steffen J.
(86) Internationale Anmeldenummer: PCT/EP2018/073476
(87) Internationale Veröffentlichungsnummer: WO 2019/057469

(56) Entgegenhaltungen:
- EP-A2- 1 126 507
- WO-A1-03/058708
- DE-A1-102006 020 513
- DE-B3-102015 013 494
- US-A- 4 619 043
- US-A1- 2016 081 198

## Beschreibung

### Hintergrund

Hier wird eine Bauteilzentrierung für eine Bauteilhandhabungsvorrichtung beschrieben. Diese Bauteilzentrierung ist im Zusammenwirken mit der Bauteilhandhabungsvorrichtung erläutert. Details hierzu sind in den Ansprüchen definiert; auch die Beschreibung und die Zeichnung enthalten relevante Angaben zum System und zur Funktionsweise sowie zu Varianten des Systems.

Ein Bauteil ist hier zum Beispiel ein (elektronisches) Halbleiterbauteil, auch als "chip" oder "die" bezeichnet. Ein solches Bauteil hat in der Regel eine prismatische Gestalt, einen im Wesentlichen polygonalen, zum Beispiel viereckigen (rechteckförmigen oder quadratischen) Querschnitt mit mehreren Mantelflächen sowie eine Stirnfläche und eine Deckfläche. Die Mantelflächen sowie die beiden (untere und obere) Deckflächen des Bauteils sind nachfolgend allgemein als Seitenflächen bezeichnet. Das Bauteil kann auch eine von vier abweichende Anzahl von Mantelflächen haben. Ein Bauteil kann auch ein optisches Bauteil (Prisma, Spiegel, Linse, etc.) sein. Insgesamt kann ein Bauteil jede geometrische Form haben.

Aus der betrieblichen Praxis der Anmelderin sind so genannte Aufnehm- und Absetzvorrichtungen bekannt, in denen Bauteile mittels eines Aufnahmewerkzeugs von einem Substrat aufgenommen und anschließend auf einem Träger oder in einem Transportbehälter oder dergl. abgelegt werden. Vor dem Ablegen des Bauteils findet üblicherweise eine Inspektion des Bauteils statt. Dazu werden Abbildungen einer oder mehrerer Seitenflächen des Bauteils mit einer oder mehreren Kameras aufgenommen und mittels automatisierter Bildverarbeitung ausgewertet.

### Stand der Technik

Die EP 1 470 747 B1 betrifft eine Chipentnahmevorrichtung, ein Chipentnahmesystem, ein Bestückungssystem sowie ein Verfahren zum Entnehmen und Weiterverarbeiten von Chips. Die Chips werden von einem Wafer entnommen und zu einer Übergabeposition transportiert und gleichzeitig gewendet. Diese Chipentnahmevorrichtung zum Entnehmen von Chips von strukturierten Halbleiter-Wafern ist ausgestattet mit einem drehbaren Entnahmewerkzeug zum Entnehmen der Chips von dem Wafer und zum Wenden der entnommenen Chips um 180° um ihre Längs- oder Querachse, und einem drehbaren Wendewerkzeug zum erneuten Wenden der entnommenen Chips um 180° um ihre Längs- oder Querachse, welches mit dem Entnahmewerkzeug zusammenwirkt. Das Entnahmewerkzeug hat eine erste Übergabeposition und das Wendewerkzeug hat eine zweite Übergabeposition, an welchen die Chips zur Weiterverarbeitung an einen Bestückkopf übergebbar sind.

Die EP 0 906 011 A2 betrifft eine Vorrichtung zum Entnehmen und Bestücken von elektrischen Bauelementen auf einem Substrat. Die Vorrichtung umfasst eine drehbare Übergabeeinrichtung, die an einer Aufnahmeposition die elektrischen Bauelemente aus einem Zuführmodul entnimmt und an einer ersten Übergabeposition einem Saugband zur Weiterverarbeitung übergibt. Mittels eines drehbaren Bestücckopfes werden die Bauelemente von dem Saugband aufgenommen und zu einer zweiten Übergabeposition transportiert.

Die WO 02/054480 A1 betrifft eine Vorrichtung zum optischen Inspizieren verschiedener Oberflächen eines zu montierenden Chips. Die Vorrichtung umfasst eine erste, obere Transportscheibe, die dazu eingerichtet ist, die Chips aus einer Zuführeinheit zu entnehmen und zu einer ersten Übergabeposition zu transportieren. Die Chips werden in Saugöffnungen gehalten, welche an der Mantelfläche der oberen Transporttrommel ausgebildet sind, und durch Drehen der oberen Transportscheibe bewegt. Die Vorrichtung weist weiterhin eine entsprechend der oberen Transportscheibe ausgebildete zweite, untere Transportscheibe auf, welche die entnommenen Chips an der ersten Übergabeposition aufnimmt und zu einer zweiten Übergabeposition transportiert. Die Vorrichtung ermöglicht eine Inspektion der Chips, indem seitlich neben den Transportscheiben Kameras angeordnet sind, die die Chips an deren Ober- und Unterseite inspizieren. Die Chips werden weiterhin relativ zur ursprünglichen Ausrichtung ungewendet an eine Sortiervorrichtung zur Weiterverarbeitung übergeben.

Die US 4,619,043 offenbart eine Vorrichtung und ein Verfahren zum Entnehmen und Anbringen von elektronischen Bauteilen, insbesondere Chips, auf einer Leiterplatte. Die Vorrichtung umfasst ein Beförderungsmittel zum Aufnehmen der Chips in Aufnahmeeinheiten und zum Transprotieren der aufgenommenen Chips zu einer ersten Übergabeposition. Das Beförderungsmittel weist dabei eine Beförderungskette und ein drehbares Kettenrad auf, welche zusammen im Eingriff stehen. Die Vorrichtung umfasst weiterhin ein drehbares Befestigungswerkzeug mit Bestückköpfen zum Aufnehmen der Chips an der ersten Übergabeposition. Das Befestigungswerkzeug ist weiterhin dazu eingerichtet, mittels einer Drehbewegung die aufgenommenen Chips zu einer zweiten Übergabeposition zu befördern, wobei sie gewendet werden.

Die JP 2-193813 betrifft eine Vorrichtung zum Aufnehmen und zum Wenden von elektronischen Komponenten, welche durch Prüfvorrichtungen inspiziert werden. Die Vorrichtung umfasst eine Zufuhreinheit, aus welcher chipartige elektronische Bauteile durch einen ersten rotierenden Körper entnommen und an dessen Umfang angeordnet werden. Durch eine Drehbewegung des rotierenden Körpers werden die elektronischen Bauteile zu einer ersten Übergabeposition transportiert, wodurch diese um ihre Längs- oder Querachse gewendet werden. Die Vorrichtung umfasst weiterhin einen zweiten rotierenden Körper, welcher die entnommenen elektronischen Bauteile an der ersten Übergabeposition aufnimmt und zu einer zweiten Übergabeposition transportiert. Dabei erfolgt ein weiteres Wenden der elektronischen Bauteile um deren Längs- oder Querachse. Die Vorrichtung ermöglicht somit, dass unterschiedliche Seiten der Bauteile inspiziert werden.

Die DE 102014116342 A1 betrifft ein Verfahren und eine Substrathaltevorrichtung, aufweisend eine Trägerplatte mit einer Aussparung zum Aufnehmen mindestens eines Halterahmens zum Halten eines Substrats mittels des mindestens einen Halterahmens in der Aussparung, wobei sich die Aussparung durch die Trägerplatte von deren Oberseite zu deren Unterseite hindurch erstreckt. Die Trägerplatte hat einen Zentrierbereich, bei dem sich eine Öffnungsweite der Aussparung von der Oberseite in Richtung zu der Unterseite kontinuierlich reduziert. Der Halterahmen hat einen Zentrierabschnitt, der beim Einlegen des mindestens einen Halterahmens in die Aussparung der bewirkt, dass der Zentrierabschnitt einen Formschluss mit dem Zentrierbereich bildet. Dadurch wird der mindestens eine Halterahmen in der Aussparung zentriert gehalten.

Die DE 4232902 A1 betrifft Substrathalter zum Transport von flachen kreisscheibenförmigen Substraten in einer Vakuum-Prozessanlage, in der das Substrat ein- oder beidseitig in beliebiger Raumlage einer Behandlung, wie z. B. Sputterbeschichten oder Plasmaätzen, unterzogen wird. Zwei gleichartige Paare federnder Haltefinger liegen in der Substratebene. Die Wirkrichtung der Haltefinger erstreckt sich in Längsrichtung hin zum Substratmittelpunkt. Die beiden Haltefinger-Paare stehen sich diametral gegenüber. Der von den Kreisscheibenradien durch die Haltepunkte eingeschlossene Winkel liegt über 0° und unter 180°. Die Haltefinger jeweils eines Paares sind auf der dem Substrat abgewandten Seite über ein gemeinsames Verbindungsglied oder über zwei gleichartig ausgebildete Verlängerungen miteinander kraftschlüssig verbunden. Die Mitte der Verbindungsglieder liegt auf einer gedachten Geraden, die durch den Kreisscheiben-Mittelpunkt läuft und bildet den Krafteinleitungsort für das jeweilige Spannglied zum Einbringen der Zuspannkraft des Substrats. Beide Spannglieder bewegen sich annähernd längs der gedachten Geraden durch den Substratmittelpunkt.

Die DE 4024642 A1 betrifft Schleuderteller für Substrate, die zwei aktive Oberflächen und einen diese überragenden umlaufenden Rand aufweisen, mit einer mittig von einer vertikalen Antriebswelle getragenen Tellerscheibe, mit auf der Oberfläche der Tellerscheibe angeordneten Auflageklötzen, die horizontale Auflageflächen und vertikale Stützflächen für den Rand des Substrates aufweisen, und mit einer axial in der Antriebswelle vorgesehenen Vakuumbohrung. Auf der Oberfläche der Tellerscheibe ist eine umlaufende Dichtung angeordnet, die an der Unterseite des Randes des Substrates anliegt. Die Vakuumbohrung ist durch die Tellerscheibe hindurch in eine zwischen der Tellerscheibe und dem Substrat gebildete, von der Dichtung umschlossene Ansaugkammer geführt.

Weiterer technologischer Hintergrund ist auch in den Dokumenten EP 2 075 829 B1, WO 2014 112 041 A1, WO 2015 083 211 A1, WO 2017 022 074 A1, WO 2013 108 398 A1, WO 2013 084 298 A1, WO 2012 073 285 A1, US 9,510,460 B2, JP 49 11 714 B2, US 7,191,511 B2, JP 55 10 923 B2, JP 57 83 652 B2, JP 2007 095 725 A, JP 2012 116 529 A, JP 2001-74664 A, JP 1-193630 A, US 5,750,979, DE 199 13 134 A1, JP 8 227 904 A veranschaulicht.

### Technisches Problem

Beim Ablösen eines Halbleiterbauteils von dem Substrat /einer Waferfolie und das Aufnehmen des Halbleiterbauteils durch das Aufnahmewerkzeug (zum Beispiel Unterdruck-Pipette) kommt es zu Lagetoleranzen des Halbleiterbauteils am Aufnahmewerkzeug. Diese Streuung von Position und Rotation der Bauteile am Aufnahmewerkzeug wird durch eine Vielfalt von Parametern beeinflusst: Adhäsion zwischen Halbleiterbauteil und Substrat / Waferfolie, Hubhöhe einer Nadel um das Halbleiterbauteil vom Substrat / der Waferfolie zu lösen, Position der Nadel bezogen auf das Zentrum des Halbleiterbauteils, Gegenkraft des Aufnahmewerkzeugs, Position des Aufnahmewerkzeugs zum Zentrum des Halbleiterbauteils beim Aufnehmen des Halbleiterbauteils, Intensität des Unterdrucks am Aufnahmewerkzeug, zur Verfügung stehende Zeit, um den Unterdruck zum Aufnehmen des Halbleiterbauteils aufzubauen, Beschaffenheit der Oberfläche des Halbleiterbauteils zum Aufnahmewerkzeug hin, Beschaffenheit der Oberfläche des Aufnahmewerkzeugs.

Des Weiteren steigen die Anforderungen der halbleiterverarbeitenden Industrie, immer kleinere Defekte der Halbleiterbauteile optisch erkennen zu können. Die optische Erkennung von Defekten ist mit angepassten Objektiven und einer damit abgestimmten Beleuchtung der zu inspizierenden Bauteile zwar möglich. Allerdings gelangen bei der notwendigen Abbildungsschärfe und der damit einhergehenden kleiner werdenden Schärfentiefe die verfügbaren Objektive an ihre Grenzen.

Wegen der Streuung der Positionen der Halbleiterbauteile am Aufnahmewerkzeug und der geringen Schärfentiefe der Objektive ist die Qualität der optischen Inspektion eingeschränkt. An unscharf abgebildeten Halbleiterbauteilen werden Defekte mit einer niedrigeren Wahrscheinlichkeit erkannt. Damit werden fehlerhafte Halbleiterbauteile fälschlicherweise nicht als funktionsuntüchtig erkannt und weiterverarbeitet / verpackt.

Konventionelle Lösungen dieses Problems sehen eine der optischen Auswertung vorgeschaltete Zentrierstation für das Halbleiterbauteil zur Erhöhung der Qualität der optischen Bauteilinspektion vor. Dabei werden die X- und Y-Position und die Rotation des Halbleiterbauteils vermessen. Anschließend werden die X- und Y-Position und die Rotation des Halbleiterbauteils korrigiert, indem das Aufnahmewerkzeug in X- und Y-Richtung verlagert und gedreht wird. Bei dieser Lösung muss jedes Aufnahmewerkzeug zusätzlich mit einem rotatorischen Antrieb ausgestattet sein oder das Aufnahmewerkzeug ist so ausgeführt, dass ein Antrieb in jedes Aufnahmewerkzeug eingreifen kann. Alternativ wird das Aufnahmewerkzeug gedreht und die Auswerte-Kamera in X- und Y-Richtung relativ zum Halbleiterbauteil verlagert. Eine weitere herkömmliche Variante sieht vor, das Halbleiterbauteil auf einem Träger abzulegen, die X- und Y-Position und die Rotation des Halbleiterbauteils auf dem Träger auszurichten, und dann das Halbleiterbauteil mit dem Aufnahmewerkzeug wieder von dem Träger aufzunehmen. Bei diesem erneuten Aufnehmen des Halbleiterbauteils von dem Träger besteht die Gefahr, dass das Halbleiterbauteil erneut relativ zum Aufnahmewerkzeug verrutscht.

Die hier vorgestellte Lösung soll eine gegenüber dem Stand der Technik verbesserte, präzise Handhabung von Bauteilen sowie deren Inspektion bei hohem Durchsatz ermöglichen.

### Vorgeschlagene Lösung

Dazu werden eine Vorrichtung und ein Verfahren angegeben. Die Vorrichtung dient zum Ausrichten und optischen Inspizieren eines an einem Aufnahmewerkzeug befindlichen Halbleiterbauteils, wobei das Aufnahmewerkzeug an einer ersten Wendeeinrichtung für das Halbleiterbauteil angeordnet ist. Diese Vorrichtung zum Ausrichten ist dazu bestimmt und eingerichtet, das Halbleiterbauteil relativ zu einem Zentrum des Aufnahmewerkzeugs in wenigstens einer Achsen-Richtung und einer Dreh-Richtung auszurichten. Dabei ist die erste Wendeeinrichtung dazu eingerichtet, um eine erste Wendeachse zu rotieren und dabei das Halbleiterbauteil aus einer ersten Aufnahmeposition in eine erste Absetzposition zu fördern. Diese Vorrichtung zum Ausrichten ist ausgestattet mit zwei aufeinander zu und voneinander weg beweglichen ersten Schiebern, die zum Beispiel parallel zueinander orientierte erste Schiebeabschnitte aufweisen. Diese beiden ersten Schiebeabschnitte sind dazu bestimmt und eingerichtet, an zwei beispielsweise einander gegenüber liegenden, ersten Seitenflächen des an dem Aufnahmewerkzeug befindlichen Halbleiterbauteils zumindest abschnittsweise zur Anlage zu kommen, um das Halbleiterbauteil auszurichten. Dazu können die ersten Schieber das Halbleiterbauteil in einer zu wenigstens einem der beiden ersten Schiebeabschnitte zum Beispiel senkrechten Richtung zu einer Inspektionsposition hinzuschieben und hinzudrehen, während das Aufnahmewerkzeug das Halbleiterbauteil hält.

### Varianten, Ausgestaltungen

Zum optischen Inspizieren einer vom Aufnahmewerkzeug abliegenden Stirnseite und/oder wenigstens einer der beiden ersten Seitenflächen des Halbleiterbauteils ist eine Kameraanordnung vorgesehen. Diese Kameraanordnung ist zu der ersten Wendeeinrichtung derart ausgerichtet, dass das Aufnahmewerkzeug mit dem daran befindlichen Halbleiterbauteil zu einer optischen Einrichtung der Kameraanordnung beabstandet ist und mit einer optischen Achse der Kameraanordnung zumindest zeitweise fluchtet.

Eine zweite Wendeeinrichtung für das Halbleiterbauteil ist vorgesehen und dazu eingerichtet, um eine zweite Wendeachse zu rotieren. Diese zweite Wendeeinrichtung übernimmt dabei das Halbleiterbauteil von der ersten Wendeeinrichtung aus deren erster Absetzposition in einer zweiten Aufnahmeposition der zweiten Wendeeinrichtung um es in eine zweite Absetzposition zu fördern. Dabei sind die erste Wendeachse und die zweite Wendeachse um einen Winkel von etwa 90° zueinander versetzt. Die erste Absetzposition der ersten Wendeeinrichtung fluchtet mit der zweiten Aufnahmeposition der zweiten Wendeeinrichtung derart, dass das Halbleiterbauteil von der ersten Wendeeinrichtung zu der zweiten Wendeeinrichtung zu übergeben ist.

Auch in der zweiten Wendeeinrichtung wird das Halbleiterbauteil vor dessen Inspektion ausgerichtet. Dazu sind ebenfalls zwei aufeinander zu und voneinander weg bewegliche zweite Schieber vorgesehen. Diese zweiten Schieber haben zum Beispiel parallel zueinander orientierte zweite Schiebeabschnitte. Die beiden zweiten Schiebeabschnitte sind dazu bestimmt und eingerichtet, an zwei zum Beispiel einander gegenüber liegenden, zweiten Seitenflächen des Halbleiterbauteils zumindest abschnittsweise zur Anlage zu kommen, um das an dem Aufnahmewerkzeug befindliche Halbleiterbauteil auszurichten. Ebenso wie an der ersten Wendeeinrichtung schieben und drehen hier die zweiten Schieber das Halbleiterbauteil in einer zu wenigstens einem der beiden zweiten Schiebeabschnitte zum Beispiel senkrechten Richtung in eine Inspektionsposition, während das Aufnahmewerkzeug das Halbleiterbauteil hält.

Unter das Halbleiterbauteil durch Hinschieben und Hindrehen zu einer Inspektionsposition ausrichten ist hier verstanden, dass die Schiebeabschnitte das Halbleiterbauteil soweit an dem Aufnahmewerkzeug verlagern, dass das Halbleiterbauteil sich in der nachfolgenden Inspektion möglichst innerhalb des Schärfetiefen-Bereichs der jeweiligen Kameraanordnung befindet. Dabei muss das Halbleiterbauteil nicht in beiden Richtungen (X- Achse und Y-Achse) und in Drehrichtung (um die Z-Achse) exakt ausgerichtet sein. Es ist ausreichend, wenn das Halbleiterbauteil mit seinen in der jeweiligen Inspektion betrachteten Seitenflächen und Stirnfläche möglichst senkrecht zur optischen Achse der jeweiligen Kameraanordnung orientiert ist und vollständig innerhalb des Sichtfelds der jeweiligen Kameraanordnung ausgerichtet ist.

In einer Variante haben die ersten und / oder die zweiten Schieber jeweils einen Antrieb, um den Abstand der jeweiligen Schiebeabschnitte von den Aufnahmewerkzeugen der jeweiligen Wendeeinrichtung in radialer Richtung bezogen auf die Wendeachse zu verändern. So hat jeder Schieber einen eigenen Antrieb, um einen Abstand des jeweiligen Schiebeabschnitts von einer Stirnfläche der jeweiligen Aufnahmewerkzeuge längs der Richtung einer jeweiligen Längsmittelachse der Aufnahmewerkzeuge zu verändern. Auf diese Weise lassen sich die Orte einstellen, an denen die jeweiligen Schiebeabschnitte an den Seiten der Halbleiterbauteile angreifen und zur Anlage kommen.

In einer weiteren Variante sind die zusammenwirkenden Schieber an der ersten und / oder der zweiten Wendeeinrichtung dazu eingerichtet und bestimmt, sich gleichsinnig und zumindest annähernd synchron zu der jeweiligen Inspektionsposition der Halbleiterbauteile hin oder von ihr weg zu bewegen. Auf diese Weise werden die Halbleiterbauteile zu der jeweiligen Inspektionsposition hin geschoben und gedreht.

Zur Justierung dient in einer Variante eine Kamera, um den Abstand der Schiebeabschnitte von der jeweiligen Stirnfläche der Aufnahmewerkzeuge in einer Richtung der jeweiligen Längsmittelachse der Aufnahmewerkzeuge zu erfassen. Damit kann im Betrieb der Anordnung für jedes der Aufnahmewerkzeuge der Abstand der Schiebeabschnitte von der jeweiligen Stirnfläche der Aufnahmewerkzeuge individuell eingestellt werden.

Die zusammenwirkenden Schieber in der Zentrierstation haben in einer Variante eine "Fußform", deren (Fuß-)Spitze zu den Aufnahmewerkzeugen hin orientiert ist. Eine Kamera erfasst den Abstand von der Fußspitze bis zur Stirnfläche der Aufnahmewerkzeuge. Bei dieser Orientierung der Spitze des Schiebers kann die Kamera den Abstand zwischen Schieber und Stirnfläche des Aufnahmewerkzeugs genau erfassen, ohne dabei das Halbleiterbauteil zu beschädigen.

So bildet die hier vorgestellte Anordnung eine integrierte Handhabungs-/Inspektionseinrichtung. Bildgebende Sensoren inspizieren alle oder fast alle Deck- und/oder Seitenfläche(n) eines Bauteils und liefern dabei auch relevante Daten zur Positionierung der Aufnahmewerkzeuge (Manipulatoren, Aufnehmer) und der Empfangsstellen.

Diese Einrichtung bildet somit einen Kern eines geschlossenen Maschinensystems mit der notwendigen prozesstechnischen Peripherie, zum Beispiel zur Bereitstellung der Bauteile (zum Beispiel Wafertisch) und Bauteil-Ablage (zum Beispiel Taschen- oder Träger-Band).

Die hier vorgestellte Bauteilhandhabungsvorrichtung übernimmt Bauteile von einem zum Beispiel horizontal im oberen Bereich der Bauteilhandhabungsvorrichtung angeordneten Bauteilvorrat (Waferscheibe) mit einer zum Beispiel ortsfesten Ausstoßeinheit. Relativ zu dieser Ausstoßeinheit bewegt sich der Bauteilvorrat in der Ebene. Die Ausstoßeinheit bewirkt durch eine Nadel oder berührungslos (z.B. durch einen Laserstrahl), dass die Bauteile einzeln von dem Bauteilvorrat freikommen und von einem Aufnehmer aufgenommen werden. Die ausgestoßenen Bauteile werden insgesamt mehreren Inspektionsprozessen zugeführt und abschließend an der zweiten Absetzposition abgelegt zu werden. Die Begriffe Empfangsstelle, Absetzposition und (Ablage-)Tasche werden hier gleichbedeutend verwendet. Schlechtteile können dabei ausgeschleust werden. Die in den Übergabevorgang integrierte optische Untersuchung des Bauteils gliedert sich in mehrere Untersuchungsvorgänge auf. Sie nutzt einen oder mehrere bildgebende Sensoren in Form von Kameraeinrichtungen zum optischen Erfassen von Deck- und/ oder Mantelfläche(n) eines Bauteils sowie der Positionen der Aufnehmer an den Übergabe-/ Empfangsstellen. Diese bildgebenden Sensoren sind dazu eingerichtet, in mehreren Untersuchungsvorgängen jeweils wenigstens ein Bild einer der Deck- und/ oder Mantelflächen eines Bauteils zu erfassen. Die Förderung / der Transport der Bauteile geschieht, während Aufnehmewerkzeuge der Wendeeinrichtungen jeweils ein Bauteil halten. Ein gehaltenes Bauteil passiert während des Transports einzelne Untersuchungsvorgänge. Einzelnen oder allen Untersuchungsvorgängen ist dabei eine Ausrichtung des Bauteils in wenigstens einer Lateral- und/oder Rotations-Richtung vorgeschaltet. So ist eine optimierte Präzision bei der Bilddatenerfassung möglich. Die erfassten (Bild-)Daten der bildgebenden Sensoren dienen dabei auch dazu, die Positionsregelung der Manipulatoren (Aufnehmer) und der Empfangsstellen zu koordinieren. Die Bauteilförderung ist dazu eingerichtet, ein Bauteil im Wesentlichen kontinuierlich oder getaktet entlang seines Pfades zu fördern.

Die hier vorgestellte Anordnung und Verfahrensweise vereint funktional zwei Aspekte: Handhabung und Inspektion. Diese beiden Funktionen werden zur schnellen und präzisen qualitativen Beurteilung mehrerer (bis zu sechs oder mehr) Seiten der Bauteile zeitlich und räumlich ineinander verwoben, während diese Bauteile schnell aus dem Bauteilvorrat vereinzelt entnommen und durch die Inspektion als Gutteile klassifiziert an der oder den Empfangsstellen präzise abgesetzt werden.

Die Bauteilhandhabungsvorrichtung hat zwei vorzugsweise geregelt betriebene, vorzugsweise im Wesentlichen orthogonal (90° plus minus bis zu 15°) zueinander angeordnete, in etwa stern- oder radförmige Wendeeinrichtungen. Die Wendeeinrichtungen könnten auch eine rechteckige Gestalt haben. Jede dieser Wendeeinrichtungen trägt mehrere, in einigen Varianten auch zu ihrer Drehachse radial verfahrbare Aufnehmer, um die Bauteile jeweils auf einem Aufnehmer fixiert innerhalb eines Schwenkwinkels zwischen Bauteil-Übernahme und -Übergabe einer oder mehreren Prozess-Stationen zur Inspektion, Schlechtteilausschleusung und ggf. weiteren Stationen zuzuführen.

Bei der hier vorgestellten Vorrichtung tragen die stern- oder radförmigen Wendeeinrichtungen die Bauteile an radial nach außen weisenden Aufnehmern, die am (gedachten) Umfang der beiden Wendeeinrichtungen angeordnet sind. Dies ist im Unterschied zu solchen Vorrichtungen zu sehen, bei denen die Aufnehmer einer oder beider Wendeeinrichtungen parallel zur deren Rotationsachse orientiert sind.

Während vorstehend mehrere Untersuchungsvorgänge erwähnt sind, soll damit kein zeitlicher Ablauf oder eine Reihenfolge (zuerst eine Bilderfassung in einem ersten und dann eine Bilderfassung in einem weiteren Untersuchungsvorgang) festgelegt sein. Vielmehr sind auch Fälle denkbar, in denen die umgekehrte Reihenfolge günstiger ist. Da abhängig von der Anzahl der Aufnehmer an den einzelnen Wendeeinrichtungen auch gleichzeitig mehrere Bauteile an jeder der Wendeeinrichtungen aufgenommen sein können, finden die Untersuchungsvorgänge auch zeitgleich, wenn auch an unterschiedlichen Bauteilen, statt.

Die in den einzelnen Untersuchungsvorgängen durch die bildgebenden Sensoren erfasste(n) (oberen/unteren) Deck- und/oder (seitlichen) Mantelfläche(n) eines Bauteils können voneinander abweichende Deck- und/oder Mantelflächen des Bauteils sein.

Ein Aspekt der optischen Untersuchung sieht vor, dass die Bauteilförderung mit einem Bauteil den Bauteilpfad im Wesentlichen ohne oder nahezu ohne Stillstand absolviert. Dabei werden während der Bewegung oder während der minimalen Stillstandszeiten eine oder mehrere Deck- und/oder Mantelflächen eines Bauteils mit den bildgebenden Sensoren erfasst. Diese Bilder werden anschließend mit Methoden der Bildverarbeitung ausgewertet. Eine Variante dieser optischen Erfassung / Untersuchung sieht vor, dass als bildgebende Sensoren eine oder mehrere Farb-Kameras oder Schwarzweiß-Kameras vorgesehen sind.

Die bildgebenden Sensoren können dabei einen oder mehrere Spiegel, optische Prismen, Linsen oder dergl. haben.

Den bildgebenden Sensoren können Strahlungs- oder Lichtquellen zugeordnet sein. Dabei kann jede Quelle dazu eingerichtet sein, Licht / Strahlung mit einem unterschiedlichen Spektral- oder Wellenlängenbereich zur Beleuchtung zumindest eines Abschnitts des Bauteils abzugeben. Die Wellenlängenbereiche können zumindest teilweise voneinander abweichen, überlappen oder übereinstimmen. So kann zum Beispiel das Licht der ersten Lichtquelle rot, und das Licht der zweiten Lichtquelle kann blau sein. Es kann aber auch die umgekehrte Zuordnung oder eine andere Wellenlängenpaarung (zum Beispiel infrarotes und sichtbares Licht) gewählt sein.

Die Lichtquellen können durch eine Steueranordnung in dem Moment jeweils kurz eingeschaltet werden, wenn sich der Aufnehmer mit dem Bauteil im jeweiligen Erfassungsbereich befindet, so dass die Deck- und/oder Mantelflächen des Bauteils mit einem kurzen Lichtblitz zur Erfassung durch den jeweiligen bildgebenden Sensor belichtet werden können. Alternativ kann eine dauerhafte Beleuchtung verwendet werden.

Der Vorrichtung ist in einer Variante eine Abgabeeinrichtung zugeordnet, die dazu eingerichtet ist, jeweils ein Bauteil aus dem strukturierten Bauteilvorrat an einen durch die Steuerung entsprechend positionierten Aufnehmer der ersten Wendeeinrichtung abzugeben. Dies kann ein Bauteil-Ausstoßer (die ejector) sein, der das Bauteil durch die Waferträgerfolie hindurch mittels einer Nadel abstößt oder ein Laserpulsgeber, der die Haftkraft des Bauteils an der Trägerfolie gezielt verringert und so das Bauteil von der Trägerfolie ablöst. Der Abgabeeinrichtung ist ein Lage- und/oder Eigenschaftssensor zugeordnet, der dazu eingerichtet ist, die Lage der Abgabeeinrichtung relativ zu dem abzugebenden Bauteil und/oder Lagedaten des abzugebenden Bauteils, und/oder Eigenschaften des abzugebenden Bauteils zu erfassen und für die Steuerung zum Betätigen der Abgabeeinrichtung zur Verfügung zu stellen.

Bei der Vorrichtung sind in einer Variante die Aufnehmerwerkzeuge der ersten und/oder der zweiten Wendeeinrichtung dazu eingerichtet, radial zur Drehachse oder das Drehzentrum der jeweiligen Wendeeinrichtung kontrolliert aus- und eingefahren zu werden, und/ oder zum Empfangen und Abgeben eines zu fördernden Bauteils kontrolliert mit Unterdruck und/oder Überdruck beaufschlagt zu werden, und/ oder um ihre jeweilige radiale Bewegungsachse unbeweglich zu sein, oder um ihre jeweilige radiale Bewegungsachse um einen Drehwinkel kontrolliert gedreht zu werden.

Bei einer Vorrichtung dieser Art sind in einer Variante den Aufnehmern der ersten und/oder der zweiten Wendeeinrichtung zum radialen Aus-/Einfahren bei der Spendestelle, der Übergabestelle zwischen den ersten und zweiten Wendeeinrichtungen diesen zugeordnete Linearantriebe vorgesehen. Diese Linearantriebe greifen in die entsprechend positionierten Aufnehmer jeweils von außerhalb der jeweiligen Wendeeinrichtungen ein und fahren den jeweiligen Aufnehmer radial aus- und ein. In einer anderen Variante fahren diese Linearantriebe den jeweiligen Aufnehmer lediglich aus, während eine Rückstellfeder den jeweiligen Aufnehmer einfährt. In einer weiteren Variante ist jedem der Aufnehmer ein bidirektionaler oder unidirektionaler Radialantrieb zugeordnet.

In einer Variante der Bauteilhandhabungsvorrichtung stellen Ventile zu jedem der einzelnen Aufnehmer individuell und positionsgerecht eine Zuführung von Unterdruck und Überdruck bereit um frei oder positionsgesteuert die Funktionen: (i) Ansaugen des Bauteils, (ii) Halten des Bauteils, (iii) Ablegen des Bauteils mit oder ohne gesteuertem Abblas-Impuls, und/oder freies Abblasen des Bauteils zu realisieren.

In einer Variante der Vorrichtung sind der ersten Wendeeinrichtung zwischen der Spendestelle und der Übergabestelle, und/oder der zweiten Wendeeinrichtung zwischen der Übergabestelle und der Ablagestelle jeweils Lage- und Eigenschaftssensoren zugeordnet. Diese Sensoren sind dazu eingerichtet, Lagedaten und/oder Eigenschaften des geförderten Bauteils und/oder Positionsdaten zur Lageregelung der Manipulatoren (Aufnehmer) und der Empfangsstellen zu erfassen und für die Steuerung zur Verfügung zu stellen.

In einer Variante der Vorrichtung sind wenigstens einige der Lage- und Eigenschaftssensoren dazu eingerichtet, jeweils wenigstens eine Deckfläche und/oder eine oder mehrere Mantelflächen des geförderten Bauteils zu inspizieren um dessen Lagedaten und/oder Eigenschaften zu erfassen und für die Steuerung zur Verfügung zu stellen.

In einer Variante der Bauteilhandhabungsvorrichtung sind der ersten und/oder der zweiten Wendeeinrichtung jeweils eine ganzzahlige Anzahl von n Aufnehmern zugeordnet. Dabei gilt n >= 2. Die Anzahl der Aufnehmer der ersten Wendeeinrichtung und die Anzahl der Aufnehmer der zweiten Wendeeinrichtung können dabei gleich oder unterschiedlich sein.

In einer Variante der Bauteilhandhabungsvorrichtung schließen die ersten, zweiten und/oder dritten Achsen zueinander jeweils einen Winkel von 90° plus/minus maximal 10° oder 15° ein.

In einer Variante der Vorrichtung sind die Lage-/Eigenschaftssensoren bildgebende Sensoren mit übereinstimmenden oder voneinander abweichenden Erfassungsspektren, oder berührend oder berührungslos distanzmessende Lagesensoren, oder berührend oder berührungslos erfassende Eigenschaftssensoren.

Die Lage- und Eigenschaftssensoren können bildgebende Sensoren mit geradlinigen oder abknickenden optischen Achsen sein.

Die Kamera-Systeme der Lage- und Eigenschaftssensoren einschließlich ihrer Spiegel- und Beleuchtungseinheiten können durch ihre räumliche Anordnung derart kombiniert sein, dass die Bauteil-Inspektion der jeweils zugewandten Bauteilfläche und zweier seiner Mantelflächen parallelisiert an einer einzigen Prozessposition realisierbar ist. Insgesamt genügen so zwei Prozesspositionen (eine an jeder Wendeeinrichtung) zur kompletten Inspektion aller sechs Seitenflächen eines zum Beispiel quaderförmigen Bauteils. Dazu werden an jeder der beiden Prozesspositionen von dem Bauteil drei der sechs Seitenflächen erfasst. Als Inspektionsposition einer jeden Wendeeinrichtung kann in einer Variante dabei die jeweils dritte Prozessposition in etwa horizontal auf Höhe der Rotations- oder Schwenkachse festgelegt sein. Jeder dieser Inspektionspositionen ist zeitlich und räumlich eine Bauteilzentrierung vorgelagert.

Zusätzliche positionsmessende Aufgaben können zwei weiteren Kamera-Systemen (Vorder-/Rückseiten-Kamera) zugeordnet sein.

In einer Variante der Bauteilhandhabungsvorrichtung sind die ersten und/oder zweiten Wendeeinrichtungen zumindest annähernd stern- oder radförmig ausgestaltet. Die Wendeeinrichtungen können präzisionsgelagert sein und ihre Positionierung längs der jeweiligen Achsen bzw. um die jeweiligen Achsen kann mittels axial angeordnetem linear bzw. rotatorisch wirkendem Antrieb erfolgen, gepaart mit einem hochauflösenden (zum Beispiel rotatorischen oder linearen) Encoder. Die jeweiligen Aufnehmer können am äußeren Umfang verteilt angeordnet sein und radial nach außen weisende Saugkontaktstellen für die zu fördernden Bauteile haben.

Ein Vorteil der axial um etwa 90° versetzten Anordnung der Wendeeinrichtungen zueinander besteht darin, dass die Bauteile in ihrer Lage während des Förder-Prozesses bei Übergabe von einer Wendeeinrichtung zur nächsten eine 90°-Drehung um die Aufnehmerachse, relativ zur jeweiligen Bewegungsebene der Aufnehmer (bzw. Wendeeinrichtung-Achse) ausführen, ohne, dass dafür der Aufnehmer selbst rotatorisch verfahrbar gelagert werden muss. Diese Orientierungsänderung der Bauteile ermöglicht wiederum eine wesentliche vereinfachte Inspektion der vier Bauteil-Schnittflächen (=Bauteilseitenflächen). Hierfür dient ein durch je ein, der Bauteil-Schnittfläche zugewandtes, orthogonal zur Aufnehmer-Bewegungsebene (also in axialer Richtung der Wendeeinrichtung) angeordnetes Kamera-System mit vorzugsweise sehr geringem Abstand zu den Bauteil-Schnittflächen (= Mantelflächen des Bauteils) selbst.

Die Erfassung der Fehlpositionierung von Aufnehmer und Bauteil zueinander bzw. zu den Übergabe- und Inspektionspositionen erfolgt unter Nutzung der Kamera- Systeme als Aufnehmer- bzw. Bauteil-Lage-erfassendes Messsystem. Bei sehr hohen Genauigkeitsanforderungen können zusätzlich jeweils drei distanzmessende Sensoren für die Bondtool-Lageerfassung je Wendeeinrichtung zusätzlich vorgesehen sein.

Die optischen Achsen der Kameras "durchdringen" die inspizierte Bauteil-Oberfläche. Sie bilden ein Bezugssystem für die Aufnehmer-Lage. Hiervon abgeleitet lassen sich durch die in einer Ebene parallel zur idealen Aufnehmer-Bewegungsebene der rotierenden Wendeeinrichtung angeordneten distanzmessenden Sensoren Abweichungen der Aufnehmer-Bewegungsbahn von der Soll-Bewegungsbahn ermitteln. Daraus sind die auftretenden Positionsfehler in den Übergabepositionen bestimm- und durch die Steuerung kompensierbar.

Die hier vorgestellten Varianten sind im Vergleich zum Stand der Technik kostengünstiger und bieten einen höheren Bauteiledurchsatz, mehr Zeit für Inspektionen und haben weniger bewegte Massen.

### Kurzbeschreibung der Figuren

Weitere Merkmale, Eigenschaften, Vorteile und mögliche Abwandlungen werden für einen Fachmann anhand der nachstehenden Beschreibung deutlich, in der auf die beigefügten Zeichnungen Bezug genommen ist. Dabei zeigen die Fig. schematisch eine optische Untersuchungseinrichtung für ein Bauteil.
Fig. 1 zeigt in einer schematischen Seitenansicht eine Vorrichtung zum Ausrichten und optischen Inspizieren eines Halbleiterbauteils, das eine Wendeeinrichtung aus einer Aufnahmeposition in eine Absetzposition fördert.
Fig. 1a zeigt in einer schematischen Draufansicht in Richtung des Pfeils AA die Vorrichtung zum Ausrichten des Halbleiterbauteils aus Fig. 1.
Fig. 1b zeigt in einer schematischen Ansicht in Richtung des Pfeils BB die Vorrichtung zum optischen Inspizieren des Halbleiterbauteils aus Fig. 1.
Fig. 2 zeigt in einer schematischen Ansicht die Vorrichtung zum Ausrichten und optischen Inspizieren des Halbleiterbauteils mit zwei zusammenwirkenden, gegeneinander um 90° gedrehten Wendeeinrichtungen.
Fig. 3a - 3c zeigen schematisch das Ausrichten des Halbleiterbauteils in Fig. 1 oder 2 zum anschließenden optischen Inspizieren in einer schematischen Draufansicht in Richtung des Pfeils CC.

### Detaillierte Beschreibung der Figuren

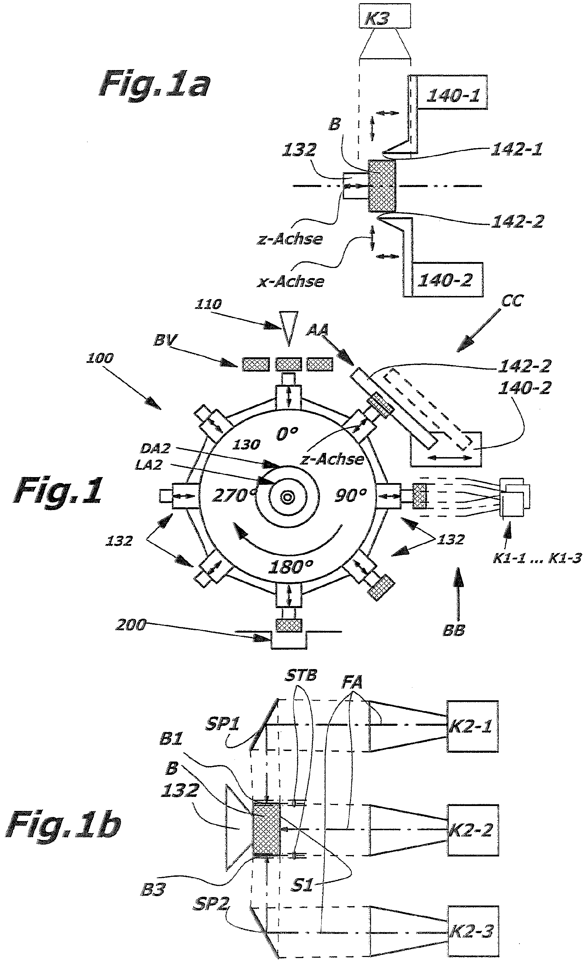

In Fig. 1 ist eine Bauteilhandhabungsvorrichtung 100 zum Entnehmen von prismatischen Bauteilen B in Form elektronischer Halbleiterchips von einem Bauteilvorrat und zum Ablegen an einer Empfangseinrichtung 200 veranschaulicht. Die hier vorgestellte Bauteilhandhabungsvorrichtung 100 übernimmt die Bauteile B von einem horizontal im oberen Bereich der Bauteilhandhabungsvorrichtung 100 angeordneten, nicht näher dargestellten Bauteilvorrat BV, zum Beispiel einer Waferscheibe.

Eine Ausstoßeinheit 110 arbeitet in der gezeigten Variante mit einer durch eine Steuerung kontrollierten Nadel oder sie arbeitet zum Beispiel berührungslos mit einem Laserstrahl, um die Bauteile B einzeln von dem Bauteilvorrat BV freizugeben, damit sie einer ersten Wendeeinrichtung 130 zugeführt werden. Diese erste Wendeeinrichtung 130 hat die Form eines Sterns oder Rades und hat an ihrem Umfang mehrere (im gezeigten Beispiel acht) Aufnehmer 132 für die vereinzelten Bauteile B. Jeder der Aufnehmer 132 ist dazu eingerichtet, wenn er sich bei der 0°-Position der ersten Wendeeinrichtung 130 der Ausstoßeinheit 110 am nächsten befindet, an einer ersten Aufnahmeposition ein Bauteil von dem strukturierten Bauteilvorrat BV zu empfangen.

Die Aufnehmer 132 sind radial nach außen weisend am (gedachten) Umfang der stern- oder radförmigen ersten Wendeeinrichtung 130 angeordnet und tragen die vom Bauteilvorrat BV übernommenen Bauteile B. Die Aufnehmer 132 sind in der gezeigten Variante zur Drehachse der ersten Wendeeinrichtung 130 radial verfahrbar. Somit können diese Aufnehmer 132 die Bauteile B, jeweils an einem der Aufnehmer 132 fixiert, innerhalb eines Schwenkwinkels - hier zwischen 0° und 180° - zwischen Bauteil-Übernahme und -Übergabe fördern.

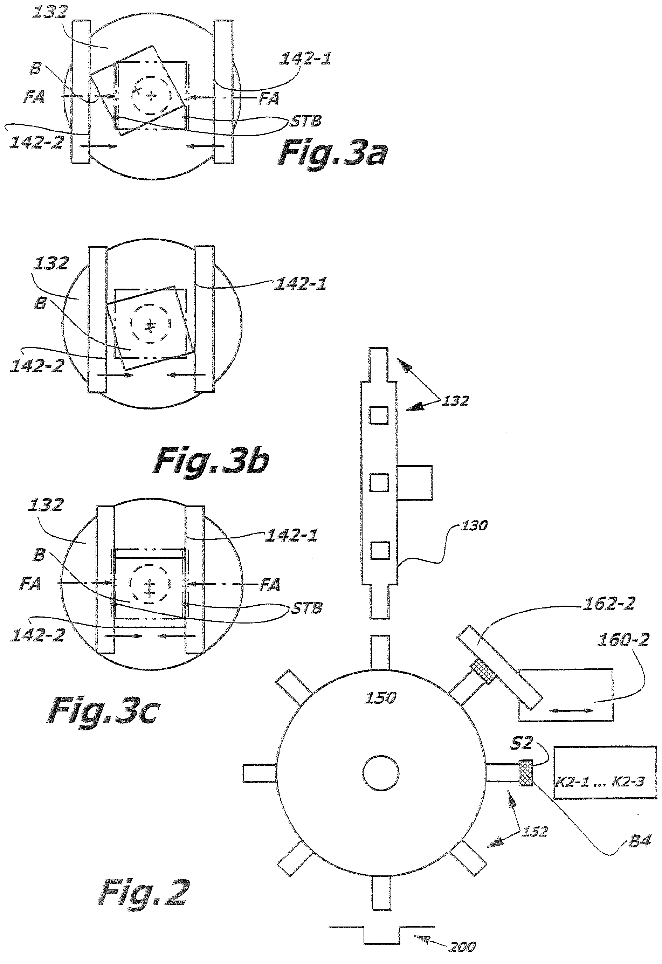

Die erste Wendeeinrichtung 130 rotiert das Bauteil B, gesteuert von der nicht weiter veranschaulichten Steuerung um ihre Drehachse, zu einer ersten Übergabestelle um einen ersten vorbestimmten Winkel, hier 180°. Dabei wird das Bauteil B um seine Längs- oder Querachse gewendet. Eine der ersten Wendeeinrichtung 130 ähnliche zweite Wendeeinrichtung 150 mit mehreren, hier ebenfalls acht, zweiten Aufnehmern 152 ist dazu eingerichtet, das Bauteil B an der Übergabestelle von einem Aufnehmer 132 der ersten Wendeeinrichtung 130 zu empfangen, wenn das Bauteil sich bei der 0°-Position der zweiten Wendeeinrichtung 150 der Übergabestelle am nächsten befindet, wie dies in Fig. 2 schematisch gezeigt ist.

Die zweite Wendeeinrichtung 150 wendet das empfangene Bauteil B, gesteuert von der Steuerung, um ihre Drehachse, um einen zweiten vorbestimmten Winkel, hier um etwa 180°, um seine Längs- oder Querachse und fördert es zu einer Ablagestelle in der Empfangseinrichtung 200.

Die Drehachsen der ersten und zweiten Wendeeinrichtungen 130, 150 schließen miteinander jeweils einen Winkel von 90° plus/minus maximal 10° oder 15° ein und orientieren sich an einem dreidimensionalen orthogonalen Koordinatensystem.

Die beiden stern- oder radförmigen Wendeeinrichtungen 130, 150 sind orthogonal zueinander angeordnet und stimmen ansonsten in ihrem Aufbau überein. Abweichend von der Darstellung in Fig. 1 kann die Anordnung der beiden Wendeeinrichtungen 130, 150 relativ zur Förderrichtung der Empfangseinrichtung 200 auch um die Z-Achse um 90° gedreht sein. In diesem Fall ist die untere Wendeeinrichtung 150 zumindest annähernd quer zur Förderrichtung der Empfangseinrichtung 200 orientiert.

Den ersten und zweiten Wendeeinrichtungen 130, 150 sind Lage- und Eigenschaftssensoren in Form von Kameraanordnungen zugeordnet. Wie in Fig. 1 gezeigt, befinden sich diese Sensoren an mehreren Stellen der Gesamtanordnung. Sie sind dazu eingerichtet, Lagedaten der ersten und zweiten Wendeeinrichtungen 130, 150, Lagedaten von an den Aufnehmern 132, 152 befindlichen Bauteilen B, sowie Eigenschaften von an den Aufnehmern 132, 152 befindlichen Bauteilen B zu erfassen. Die dabei gewonnenen Daten werden der Steuerung zur Verfügung gestellt. In der hier veranschaulichten Ausführung ist eine erste Kameraanordnung K1 mit drei Kameras K1-1, K1-2, K-3 - in Fig. 1 nur teilweise zu sehen - an der Peripherie der ersten Wendeeinrichtung 130 bei 90° auf das daran vorbeigeführte Bauteil B gerichtet. Details zu dieser Kameraanordnung K1 werden im Zusammenhang mit Fig. 1b erläutert. Eine dieser Kameraanordnung K1 entsprechende Kameraanordnung K2 mit drei Kameras ist an der Peripherie der zweiten Wendeeinrichtung 150 bei 90° auf das daran vorbeigeführte Bauteil B gerichtet (siehe Fig. 2).

Die Steuerung ist dazu eingerichtet, mittels eines Drehantriebes DA1 die erste Wendeeinrichtung 130 um ihre Drehachse kontrolliert zu drehen und mittels eines Linearantriebes LA1 die erste Wendeeinrichtung 130 längs ihrer Drehachse kontrolliert zu verfahren. Analog hat die zweite Wendeeinrichtung 150 einen nicht weiter veranschaulichten Drehantrieb und einen Linearantrieb.

Die bildgebenden Sensoren inspizieren die Deck- und/oder Seitenfläche(n) des Bauteils B und liefern dabei auch relevante Daten zur Positionierung der ersten und zweiten Wendeeinrichtungen 130, 150 längs und um deren Achsen, sowie der Aufnehmer 132, 152 und der an ihnen befindlichen Bauteile B.

Zum Ansaugen des Bauteils B in den Aufnehmern 132, 152, zum Halten des Bauteils B in den Aufnehmern 132, 152, zum Ablegen des Bauteils B mit oder ohne gesteuertem Abblas-Impuls, und zum freien Abblasen des Bauteils B aus den Aufnehmern 132, 152 sind diese mit einer nicht weiter veranschaulichten Pneumatikeinheit verbunden. Die Pneumatikeinheit beaufschlagt, von der Steuerung kontrolliert, die einzelnen Aufnehmer 132, 152 ventilgesteuert zum jeweils erforderlichen Zeitpunkt oder Zeitraum mit Über- oder Unterdruck um die Bauteile B einzeln aufzunehmen, zu halten und wieder abzugeben.

Bevor ein Bauteil B einem bildgebenden Sensor zum Beispiel in Gestalt der Kameraanordnung K1-1... K1-3 (siehe Fig. 1b) in der 90° Position in der Fig. 1 zum Inspizieren die Deck- und/oder Seitenfläche(n) des Bauteils B zugeführt wird, sorgt eine Vorrichtung 300 zum Ausrichten des an dem Aufnahmewerkzeug 132, 152 befindlichen Halbleiterbauteils B dafür, dass dieses zur Inspektion durch die Kameraanordnung K1-1... K1-3 optimal ausgerichtet ist. Dies soll sicherstellen, dass auch sehr kleine optische Bauteildefekte erkannt werden können. Hierzu hat die Kameraanordnung K1-1... K1-3 speziell angepasste Objektive und eine an die zu inspizierenden Flächen hinsichtlich Strahlungsintensität und Lichtwellenlänge angepasste Beleuchtung. Für die notwendige Abbildungsschärfe liegt die Schärfentiefe der Objektive in einem sehr engen Bereich. Dazu werden die jeweiligen zu inspizierenden Seitenflächen des Halbleiterbauteils B möglicht genau auf den Fokusabstand FA (Siehe Fig. 1, 3c) der jeweiligen Kameraanordnung K1-1... K1-3 ausgerichtet. Außerdem drängen die zusammenwirkenden Schiebeabschnitte die jeweiligen zu inspizierenden Seitenflächen des Halbleiterbauteils B soweit in Richtung der Inspektionsposition, dass sich diese Seitenflächen und auch die Stirnfläche in den Schärfetiefenbereichen STB (Siehe Fig. 1, 3c) der jeweiligen Kameraanordnung K1-1... K1-3 befindet. Bei den Objektiven der Kameraanordnung K1-1... K1-3 ist in einer Ausgestaltung die chromatische Aberration zwischen dem IR-Lichtbereich und dem blauen Lichtbereich minimiert. Zum Beispiel haben außerdem die Objektive der Kameraanordnung Kl-1... K1-3 einen Betrachtungsabstand von den jeweiligen zu inspizierenden Seitenflächen des Halbleiterbauteils B von etwa 104.1 mm, plus etwa 2 mm, minus etwa 1 mm und einen Schärfetiefenbereich STB von etwa 0.1 mm.

Um das an dem Aufnahmewerkzeug 132, 152 befindliche Halbleiterbauteil B optimal optisch inspizieren zu können, dient die Vorrichtung 300 zum Ausrichten des Halbleiterbauteils B. Die Vorrichtung 300 richtet das Halbleiterbauteil B relativ zu einem Zentrum des Aufnahmewerkzeugs in wenigstens einer Achsen-Richtung (x-Achse oder y-Achse) quer zur Mittellängsachse (z-Achse) des jeweiligen Aufnahmewerkzeugs 132, 152 und / oder einer Dreh-Richtung längs der Mittellängsachse (z-Achse) des jeweiligen Aufnahmewerkzeugs 132, 152 aus.

Die Wendeeinrichtung 130, 150 fördert dazu, während sie um ihre Drehachse rotiert, das Halbleiterbauteil B aus einer Aufnahmeposition (bei 0°) in eine Absetzposition (bei 180°). In den Fig. 1 und 2 findet das Ausrichten etwa bei 45° statt. Dort sind zwei miteinander fluchtende, aufeinander zu und voneinander weg beweglichen erste Schieber 140-1 und 140-2 angeordnet, zwischen denen das Halbleiterbauteil B hindurch gefördert wird. Diese Schieber 140-1 und 140-2 haben Schiebeabschnitte 142-1, 142-2, welche eine an die Gestalt der Seitenfläche des Halbleiterbauteils B angepasste Kontur haben, so dass die beiden Schiebeabschnitte 142-1, 142-2 geeignet sind, an zwei ersten Seitenflächen B1, B3 des Halbleiterbauteils B zur Anlage zu kommen. Wie in den Abbildungen in den Fig. 3a - 3c veranschaulicht, drängen die beiden sich aufeinander zu bewegenden Schiebeabschnitte 142-1, 142-2 das an dem Aufnahmewerkzeug 132, 152 befindliche Halbleiterbauteil B in eine ausgerichtete Inspektionsposition, während das Aufnahmewerkzeug 132, 152 das Halbleiterbauteil B hält.

Wie in Fig. 1b veranschaulicht, wird an der ersten Wendeeinrichtung 130 in der Inspektionsposition (bei 90° in der Fig. 1) zum optischen Inspizieren der vom Aufnahmewerkzeug 132 abliegenden Stirnseite S1 und der beiden Seitenflächen B1, B3 (siehe Fig. 1b) des Halbleiterbauteils B durch die Kameraanordnung K1-1... K1-3 jeweils ein Bildeinzug angefertigt, wenn sich das Halbleiterbauteil B in der Inspektionsposition (bei 90°) befindet. Analog dazu wird an der zweiten Wendeeinrichtung 150 in der Inspektionsposition (ebenfalls bei 90°) zum optischen Inspizieren der vom Aufnahmewerkzeug 152 abliegenden Stirnseite S1 und der beiden Seitenflächen B2, B4 des Halbleiterbauteils B durch die Kameraanordnung K2-1... K2-3 jeweils ein Bildeinzug angefertigt, wenn sich das Halbleiterbauteil B in der Inspektionsposition (bei 90°) befindet. Dazu ist vorgesehen, dass die Aufnahmewerkzeuge 132, 152 an der jeweiligen Wendeeinrichtung 130, 150 derart angeordnet und ausgerichtet ist, dass es mit dem daran befindlichen Halbleiterbauteil B zu einer optischen Einrichtung (zum Beispiel den Spiegeln SP1 und SP2) oder dem Objektiv der jeweiligen Kameraanordnung K1-1... K1-3, K2-1... K2-3 beabstandet ist und mit einer optischen Achse der Kameraanordnung K1-1... K1-3, K2-1... K2-3 zumindest zeitweise fluchtet.

Die erste und die zweite Wendeeinrichtung 130, 150 sind gleich aufgebaut haben erste und zweite aufeinander zu und voneinander weg bewegliche Schieber 140-1, 140-2; 160-1, 160-2 (Siehe Fig. 1, 2), die ebenfalls gleich aufgebaut sind. Jeder der ersten und zweiten Schieber hat einen Antrieb, um den Abstand der jeweiligen Schiebeabschnitte 142-1, 142-2; 162-1, 162-2 von den Aufnahmewerkzeugen 132, 152 der jeweiligen Wendeeinrichtung 130, 150 längs der Mittellängsachse (z-Achse) der Aufnahmewerkzeuge 132, 152, also in radialer Richtung bezogen auf die Dreh- oder Wendeachse der jeweiligen Wendeeinrichtung 130, 150 zu verändern.

Zur Justierung dient Kamera K3, um den Abstand der Schiebeabschnitte 142-1, 142-2; 162-1, 162-2 von der jeweiligen Stirnfläche der Aufnahmewerkzeuge 132, 152 in einer Richtung der jeweiligen Längsmittelachse der Aufnahmewerkzeuge zu erfassen. Damit kann im Betrieb der Anordnung für jedes der Aufnahmewerkzeuge 132, 152 der Abstand der Schiebeabschnitte 142-1, 142-2; 162-1, 162-2 von der jeweiligen Stirnfläche der Aufnahmewerkzeuge 132, 152 individuell eingestellt werden. Dies erlaubt ein präzises Ausrichten der Halbleiterbauteil B in der Inspektionsposition.

Jeder Schieber hat außerdem einen eigenen Antrieb, um die jeweils zusammenwirkenden Schieber mit ihren Schiebeabschnitten 142-1, 142-2; 162-1, 162-2 mit dem jeweiligen Halbleiterbauteil B zwischen sich, siehe auch Fig. 3a - 3c, an der ersten und der zweiten Wendeeinrichtung 130, 150 gleichsinnig und zumindest annähernd synchron zu der jeweiligen Inspektionsposition hin oder von ihr weg zu bewegen.

Die zusammenwirkenden Schieber in der Zentrierstation haben in der hier veranschaulichten Variante eine "Fußform", deren Fuß-Spitze zu den Stirnflächen der Aufnahmewerkzeuge 132, 152 hin orientiert ist. Die Kamera K3 erfasst den Abstand von der Fußspitze bis zur radial außenliegenden Stirnfläche der Aufnahmewerkzeuge 132, 152.

Durch die Inspektion des Halbleiterbauteils B zuerst an der ersten und dann an der zweiten Wendeeinrichtung 130, 150, im Zusammenwirken mit dem jeweiligen vorgelagerten Ausrichten des Halbleiterbauteils B sind alle vier Seitenflächen B1 - B4 und die beiden Stirnflächen S1, S2 einer optischen Inspektion zugänglich.

Die erste und die zweite Kameraanordnungen K1 und K2 sind als Lage- und Eigenschaftssensoren mit ihren jeweiligen drei Kameras an der Peripherie der ersten bzw. der zweiten Wendeeinrichtung 130, 150 bei etwa 90° auf die drei Seiten B1, B3 und S1 des Bauteils B bzw. auf die drei Seiten B2, B4 und S2 des Bauteils B gerichtet.

Eine Draufsicht auf die Kameraanordnung K1 bzw. K2 mit ihren drei Kameras K1-1, K1-2 und K1-3; K2-1, K2-2 und K2-3 ist in Fig. 1b veranschaulicht. Hierbei inspiziert die mittlere Kamera die jeweilige Deckfläche S1 bzw. S2 des Bauteils B und die beiden äußeren Kameras über jeweilige Spiegel SP1 und SP2 die Seitenflächen des Bauteils B. Aus den dabei erfassten Bildeinzügen lassen sich etwaige Fehler des Bauteils B an diesen Flächen bestimmen.

## Patentansprüche

1. Vorrichtung zum Ausrichten und optischen Inspizieren eines an einem Aufnahmewerkzeug (132) befindlichen Halbleiterbauteils (B), wobei
- das Aufnahmewerkzeug (132) an einer ersten Wendeeinrichtung (130) für das Halbleiterbauteil (B) angeordnet ist, und
- wobei die Vorrichtung dazu bestimmt und eingerichtet ist, das Halbleiterbauteil (B) relativ zu einem Zentrum des Aufnahmewerkzeugs (132) in wenigstens einer Achsen-Richtung und/oder einer Dreh-Richtung auszurichten, wobei
- die erste Wendeeinrichtung (130) dazu eingerichtet ist, um eine erste Wendeachse zu rotieren und dabei das Halbleiterbauteil (B) aus einer ersten Aufnahmeposition in eine erste Absetzposition zu fördern, mit
- zwei aufeinander zu und voneinander weg beweglichen ersten Schiebern (140-1, 140-2), die erste Schiebeabschnitte (142-1, 142-2) aufweisen, wobei
- die beiden ersten Schiebeabschnitte (142-1, 142-2) dazu bestimmt und eingerichtet sind, an zwei ersten Seitenflächen des Halbleiterbauteils (B) zumindest abschnittsweise zur Anlage zu kommen, so dass die beiden ersten Schiebeabschnitte (142-1, 142-2) das an dem Aufnahmewerkzeug (132) befindliche Halbleiterbauteil (B) ausrichten, indem die ersten Schieber (140-1, 140-2) dazu bestimmt und eingerichtet sind, das Halbleiterbauteil (B) in eine Inspektionsposition hinzuschieben und/oder hinzudrehen, während das Aufnahmewerkzeug (132) das Halbleiterbauteil (B) hält.

2. Vorrichtung nach Anspruch 1, wobei zum optischen Inspizieren einer vom Aufnahmewerkzeug (132) abliegenden Stirnseite und/oder wenigstens einer der beiden ersten Seitenflächen des Halbleiterbauteils (B) eine Kameraanordnung (K1) vorgesehen ist, die zu der ersten Wendeeinrichtung (130) derart ausgerichtet ist, dass das Aufnahmewerkzeug (132) mit dem daran befindlichen Halbleiterbauteil (B) zu einer optischen Einrichtung der Kameraanordnung (K1) beabstandet ist und mit einer optischen Achse der Kameraanordnung (K1) zumindest zeitweise fluchtet.

3. Vorrichtung nach Anspruch 1 oder 2, wobei
- eine zweite Wendeeinrichtung (150) für das Halbleiterbauteil (B) vorgesehen ist, die dazu eingerichtet ist, um eine zweite Wendeachse zu rotieren und dabei das Halbleiterbauteil (B) von der ersten Wendeeinrichtung (130) aus deren erster Absetzposition in einer zweiten Aufnahmeposition der zweiten Wendeeinrichtung (150) zu übernehmen für ein Fördern des Halbleiterbauteils (B) in eine zweite Absetzposition, wobei die erste Wendeachse und die zweite Wendeachse um einen Winkel von etwa 90° zueinander versetzt sind, und wobei die erste Absetzposition der ersten Wendeeinrichtung (130) mit der zweiten Aufnahmeposition der zweiten Wendeeinrichtung (150) derart fluchtet, dass das Halbleiterbauteil (B) von der ersten Wendeeinrichtung (130) zu der zweiten Wendeeinrichtung (150) zu übergeben ist.

4. Vorrichtung nach Anspruch 3, wobei die zweite Wendeeinrichtung (150) für das Halbleiterbauteil (B)
- zwei aufeinander zu und voneinander weg bewegliche zweite Schieber (160-1, 160-2) aufweist, die parallel zueinander orientierte zweite Schiebeabschnitte (162-1, 162-2) aufweisen, wobei
- die beiden zweiten Schiebeabschnitte (162-1, 162-2) dazu bestimmt und eingerichtet sind, an zwei einander gegenüber liegenden, zweiten Seitenflächen des Halbleiterbauteils (B) zumindest abschnittsweise zur Anlage zu kommen, so dass die beiden zweiten Schiebeabschnitte (162-1, 162-2) das an einem Aufnahmewerkzeug (152) der zweiten Wendeeinrichtung (150) befindliche Halbleiterbauteil (B) ausrichten, indem die zweiten Schieber (160-1, 160-2) das Halbleiterbauteil (B) in einer zu den beiden zweiten Schiebeabschnitten (162-1, 162-2) senkrechten Richtung in eine Inspektionsposition schieben und/oder in die Inspektionsposition drehen, während das Aufnahmewerkzeug (152) der zweiten Wendeeinrichtung (150) das Halbleiterbauteil (B) hält.

5. Vorrichtung nach einem der vorhergehenden Ansprüche, wobei die ersten und / oder die zweiten Schieber (140-1, 140-2; 160-1, 160-2) einen Antrieb aufweisen, der bewirkt, dass die ersten und/oder zweiten Schieber (140-1, 140-2; 160-1, 160-2) den Abstand der jeweiligen Schiebeabschnitte (142-1, 142-2; 162-1, 162-2) von den Aufnahmewerkzeugen (132, 152) der jeweiligen Wendeeinrichtung (130, 150) in radialer Richtung bezogen auf die jeweilige Wendeachse verändern.

6. Vorrichtung nach einem der vorhergehenden Ansprüche, wobei jeder Schieber (140-1, 140-2; 160-1, 160-2) einen eigenen Antrieb aufweist, der bewirkt, dass ein Abstand des jeweiligen Schiebeabschnitts (142-1, 142-2; 162-1, 162-2) von einer Stirnfläche der jeweiligen Aufnahmewerkzeuge (132, 152) längs der Richtung einer jeweiligen Längsmittelachse der Aufnahmewerkzeuge (132, 152) sich verändern.

7. Vorrichtung nach einem der vorhergehenden Ansprüche, wobei die zusammenwirkenden Schieber (140-1, 140-2; 160-1, 160-2) an der ersten und / oder der zweiten Wendeeinrichtung (130, 150) dazu eingerichtet und bestimmt sind, sich gleichsinnig und zumindest annähernd synchron zu der jeweiligen Inspektionsposition hin oder von ihr weg zu bewegen.

8. Vorrichtung nach einem der vorhergehenden Ansprüche, wobei eine Kamera (K1, K2, K3) vorgesehen ist, die dazu bestimmt ist, den Abstand der Schiebeabschnitte (142-1, 142-2; 162-1, 162-2) von der jeweiligen Stirnfläche der Aufnahmewerkzeuge (132, 152) in einer Richtung der jeweiligen Längsmittelachse der Aufnahmewerkzeuge (132, 152) zu erfassen.

9. Verfahren zum Ausrichten und optischen Inspizieren eines an einem Aufnahmewerkzeug (132) befindlichen Halbleiterbauteils, wobei das Aufnahmewerkzeug an einer ersten Wendeeinrichtung (130) für das Halbleiterbauteil (B) angeordnet ist, und wobei das Halbleiterbauteil relativ zu einem Zentrum des Aufnahmewerkzeugs in wenigstens einer Achsen-Richtung und/oder einer Dreh-Richtung ausgerichtet wird, wobei das Halbleiterbauteil um eine erste Wendeachse rotiert wird und dabei das Halbleiterbauteil aus einer ersten Aufnahmeposition in eine erste Absetzposition befördert wird, und zwei aufeinander zu und voneinander weg bewegliche erste Schieber (140-1, 140-2) mit ersten Schiebeabschnitten (142-1, 142-2) die an zwei ersten Seitenflächen des Halbleiterbauteils zumindest abschnittsweise zur Anlage kommen, so dass die beiden ersten Schieber das an dem Aufnahmewerkzeug befindliche Halbleiterbauteil auszurichten, indem die ersten Schieber das Halbleiterbauteil in eine Inspektionsposition hinschieben und/oder hindrehen, während das Aufnahmewerkzeug das Halbleiterbauteil hält.

10. Verfahren nach Anspruch 9, wobei eine vom Aufnahmewerkzeug abliegende Stirnseite und/oder wenigstens eine der beiden ersten Seitenflächen des Halbleiterbauteils mittels einer Kameraanordnung inspiziert werden, die zu der ersten Wendeeinrichtung derart ausgerichtet wird, dass das Aufnahmewerkzeug mit dem daran befindlichen Halbleiterbauteil zu einer optischen Einrichtung der Kameraanordnung beabstandet ist und mit einer optischen Achse der Kameraanordnung zumindest zeitweise fluchtet.

11. Verfahren nach Anspruch 9 oder 10, wobei eine zweite Wendeeinrichtung um eine zweite Wendeachse rotiert und dabei das Halbleiterbauteil von der ersten Wendeeinrichtung aus deren erster Absetzposition in einer zweiten Aufnahmeposition der zweiten Wendeeinrichtung übernimmt für ein Fördern des Halbleiterbauteils in eine zweite Absetzposition, wobei die erste Wendeachse und die zweite Wendeachse um einen Winkel von etwa 90° zueinander versetzt sind, und wobei die erste Absetzposition der ersten Wendeeinrichtung mit der zweiten Aufnahmeposition der zweiten Wendeeinrichtung derart fluchtet, dass das Halbleiterbauteil von der ersten Wendeeinrichtung zu der zweiten Wendeeinrichtung zu übergeben ist.

12. Verfahren nach einem der Ansprüche 9 bis 11, wobei der zweiten Wendeeinrichtung für das Halbleiterbauteil zum Ausrichten und optischen Inspizieren gleiche Mittel zugeordnet werden, die bewirken, dass das an dem Aufnahmewerkzeug befindliche Halbleiterbauteil ausgerichtet wird, indem das Halbleiterbauteil in eine Inspektionsposition hingeschoben und/oder hingedreht wird, während das Aufnahmewerkzeug das Halbleiterbauteil hält.

13. Verfahren nach einem der Ansprüche 9 bis 12, wobei der Abstand der jeweiligen Schiebeabschnitte von den Aufnahmewerkzeugen der jeweiligen Wendeeinrichtung in radialer Richtung bezogen auf die Wendeachse verändert wird.

14. Verfahren nach einem der Ansprüche 9 bis 13, wobei die zusammenwirkenden Schieber an der ersten und / oder der zweiten Wendeeinrichtung sich gleichsinnig und zumindest annähernd synchron zu der jeweiligen Inspektionsposition hin oder von ihr weg bewegen.

## Claims

1. Device for aligning and optically inspecting a semiconductor component (B) located on a pick-up tool (132), wherein
- the pick-up tool (132) is arranged on a first turning device (130) for the semiconductor component (B), and
- wherein the device is designed and arranged to align the semiconductor device (B) relative to a centre of the pick-up tool (132) in at least one of an axial direction and a rotational direction, wherein
- the first turning device (130) is arranged to rotate about a first turning axis and thereby convey the semiconductor component (B) from a first receiving position to a first depositing position, with
- two first slides (140-1, 140-2) movable towards and away from each other and having first sliding portions (142-1, 142-2), wherein
- the two first slide sections (142-1, 142-2) are intended and arranged to come into contact at least with sections of two first side surfaces of the semiconductor component (B), so that the two first slide sections (142-1, 142-2) align the semiconductor component (B) located on the receiving tool (132), in that the first sliders (140-1, 140-2) are intended and arranged to slide and/or rotate the semiconductor component (B) towards an inspection position while the receiving tool (132) holds the semiconductor component (B).

2. Device according to claim 1, wherein, for the optical inspection of an end face remote from the pick-up tool (132) and/or at least one of the two first side faces of the semiconductor component (B), a camera arrangement (K1) is provided which is aligned with the first turning device (130) in such a way that the pick-up tool (132) with the semiconductor component (B) located thereon is spaced apart from an optical device of the camera arrangement (K1) and is at least temporarily aligned with an optical axis of the camera arrangement (K1).

3. Device according to claim 1 or 2, wherein
- a second turning device (150) for the semiconductor component (B) is provided, which is arranged to rotate about a second turning axis and thereby to take over the semiconductor component (B) from the first turning device (130) from its first depositing position in a second receiving position of the second turning device (150) for conveying the semiconductor component (B) into a second depositing position, wherein the first turning axis and the second turning axis are offset from one another by an angle of approximately 90°, and wherein the first depositing position of the first turning device (130) is aligned with the second receiving position of the second turning device (150) such that the semiconductor component (B) is to be transferred from the first turning device (130) to the second turning device (150).

4. Device according to claim 3, wherein the second turning device (150) for the semiconductor component (B)
- comprises two second slides (160-1, 160-2) which are movable towards and away from each other and which comprise second slide portions (162-1, 162-2) oriented parallel to each other, wherein
- the two second pushing sections (162-1, 162-2) are intended and arranged to come into contact with two opposing second side surfaces of the semiconductor component (B) at least in sections, so that the two second pushing sections (162-1, 162-2) align the semiconductor component (B) located on a receiving tool (152) of the second turning device (150), by the second pushers (160-1, 160-2) pushing the semiconductor device (B) to an inspection position and/or rotating the semiconductor device (B) to the inspection position in a direction perpendicular to the two second pushing portions (162-1, 162-2) while the receiving tool (152) of the second turning device (150) holds the semiconductor device (B).

5. Device according to any one of the preceding claims, wherein the first and/or the second sliders (140-1, 140-2; 160-1, 160-2) comprise a drive which causes the first and/or second sliders (140-1, 140-2; 160-1, 160-2) to change the distance of the respective slide sections (142-1, 142-2; 162-1, 162-2) from the receiving tools (132, 152) of the respective turning device (130, 150) in the radial direction with respect to the respective turning axis.

6. Device according to any one of the preceding claims, wherein each slider (140-1, 140-2; 160-1, 160-2) has a dedicated drive which causes a distance of the respective slider portion (142-1, 142-2; 162-1, 162-2) from an end face of the respective pick-up tools (132, 152) to vary along the direction of a respective longitudinal central axis of the pick-up tools (132, 152).

7. Device according to any one of the preceding claims, wherein the cooperating slides (140-1, 140-2; 160-1, 160-2) on the first and/or the second turning device (130, 150) are arranged and intended to move in the same direction and at least approximately synchronously towards or away from the respective inspection position.

8. Device according to any one of the preceding claims, wherein a camera (K1, K2, K3) is provided which is adapted to detect the distance of the sliding portions (142-1, 142-2; 162-1, 162-2) from the respective end face of the receiving tools (132, 152) in a direction of the respective longitudinal central axis of the receiving tools (132, 152).

9. Method for aligning and optically inspecting a semiconductor component located on a pick-up tool (132), wherein the pick-up tool is arranged on a first turning device (130) for the semiconductor component (B), and wherein the semiconductor component is aligned relative to a centre of the pick-up tool in at least one axis direction and/or a direction of rotation, wherein the semiconductor component is rotated about a first turning axis and in so doing the semiconductor component is conveyed from a first receiving position into a first depositing position, and two f sliders (140-1, 140-2) having first slide portions (142-1, 142-2), which can be moved towards and away from one anotherso as to abut at least in sections two first side surfaces of the semiconductor device, so that the two first sliders align the semiconductor device located on the pickup tool by sliding and/or rotating the semiconductor device to an inspection position while the pickup tool holds the semiconductor device.

10. Method according to claim 9, wherein an end face remote from the pick-up tool and/or at least one of the first two side faces of the semiconductor component are inspected by means of a camera arrangement which is aligned with the first turning device in such a way that the pick-up tool with the semiconductor component located thereon is spaced apart from an optical device of the camera arrangement and is at least temporarily aligned with an optical axis of the camera arrangement.

11. Method according to claim 9 or 10, wherein a second turning device rotates about a second turning axis and thereby takes over the semiconductor component from the first turning device from its first depositing position in a second receiving position of the second turning device for conveying the semiconductor component into a second depositing position, wherein the first turning axis and the second turning axis are offset from one another by an angle of approximately 90°, and wherein the first depositing position of the first turning device is aligned with the second receiving position of the second turning device such that the semiconductor component is to be transferred from the first to the second turning device.

12. A method according to any one of claims 9 to 11, wherein the second semiconductor device turning means for alignment and optical inspection is associated with like means for causing the semiconductor device located on the pick-up tool to be aligned by pushing and/or turning the semiconductor device to an inspection position while the pick-up tool holds the semiconductor device.

13. A method according to any one of claims 9 to 12, wherein the distance of the respective slider portions from the receiving tools of the respective turning device is changed in radial direction with respect to the turning axis.

14. A method according to any one of claims 9 to 13, wherein the cooperating sliders on the first and/or the second turning device move in the same direction and at least approximately synchronously towards or away from the respective inspection position.

## Revendications

1. Appareil pour aligner et inspecter optiquement un dispositif semi-conducteur (B) situé sur un outil de prélèvement (132), dans lequel
- l'outil de saisie (132) est disposé sur un premier dispositif de tournage (130) pour le composant semi-conducteur (B), et
- dans lequel le dispositif est conçu et agencé pour aligner le dispositif semi-conducteur (B) par rapport à un centre de l'outil de saisie (132) dans au moins l'une d'une direction axiale et d'une direction de rotation, dans lequel
- le premier dispositif de rotation (130) est agencé pour tourner autour d'un premier axe de rotation et transporter ainsi le composant semi-conducteur (B) d'une première position de réception à une première position de dépôt, avec
- deux premières glissières (140-1, 140-2) pouvant se rapprocher et s'éloigner l'une de l'autre et ayant des premières parties coulissantes (142-1, 142-2), dans lesquelles
- les deux premières sections de glissement (142-1, 142-2) sont destinées et disposées pour venir en contact avec deux premières surfaces latérales du composant semi-conducteur (B) au moins par sections, de sorte que les deux premières sections de glissement (142-1, 142-2) alignent le composant semi-conducteur (B) situé sur l'outil de réception (132), en ce que les premiers coulisseaux (140-1, 140-2) sont destinés et disposés pour faire glisser et/ou tourner le composant semi-conducteur (B) vers une position d'inspection tandis que l'outil de réception (132) maintient le composant semi-conducteur (B).

2. Dispositif selon la revendication 1, dans lequel, pour le contrôle optique d'une face frontale éloignée de l'outil de prélèvement (132) et/ou d'au moins l'une des deux premières faces latérales du composant semi-conducteur (B), il est prévu un dispositif de caméra (K1) qui est orienté vers le premier dispositif de rotation (130) de telle sorte que l'outil de prélèvement (132) avec le composant semi-conducteur (B) qui s'y trouve est à distance d'un dispositif optique du dispositif de caméra (K1) et est orienté au moins temporairement vers un axe optique du dispositif de caméra (K1).

3. Dispositif selon la revendication 1 ou 2, dans lequel
- un second dispositif de rotation (150) pour le composant semi-conducteur (B) est prévu, qui est agencé pour tourner autour d'un second axe de rotation et pour tourner ainsi le composant semi-conducteur (B).
semi-conducteur (B) du premier dispositif de retournement (130) depuis sa première position de dépôt dans une deuxième position de réception du deuxième dispositif de retournement (150) pour transporter le composant semi-conducteur (B) dans une deuxième position de dépôt, dans lequel le premier axe de retournement et le deuxième axe de retournement sont décalés l'un par rapport à l'autre d'un angle d'environ 90°, et dans lequel la première position de mise en place du premier dispositif de rotation (130) est alignée avec la seconde position de prélèvement du second dispositif de rotation (150) de sorte que le composant semi-conducteur (B) doit être transféré du premier dispositif de rotation (130) au second dispositif de rotation (150).

4. Dispositif selon la revendication 3, dans lequel le deuxième dispositif de tournage (150) pour le composant semi-conducteur (B)
- deux secondes glissières (160-1, 160-2) qui peuvent être rapprochées et éloignées l'une de l'autre et qui ont des secondes parties de glissière (162-1, 162-2) orientées parallèlement l'une à l'autre, dans lesquelles
- les deux secondes sections de poussée (162-1, 162-2) sont destinées et disposées pour venir en contact avec deux secondes surfaces latérales opposées du composant semi-conducteur (B) au moins par sections, de sorte que les deux secondes sections de poussée (162-1, 162-2) alignent le composant semi-conducteur (B) situé sur un outil de réception (152) du second dispositif de tournage (150), par les seconds poussoirs (160-1, 160-2) poussant le dispositif à semi-conducteur (B) vers une position d'inspection et/ou faisant tourner le dispositif à semi-conducteur (B) vers la position d'inspection dans une direction perpendiculaire aux deux secondes parties de poussoir (162-1, 162-2) tandis que l'outil de réception (152) du second dispositif de rotation (150) maintient le dispositif à semi-conducteur (B).

5. Dispositif selon l'une quelconque des revendications précédentes, dans lequel le premier et/ou le deuxième coulisseau (140-1, 140-2 ; 160-1, 160-2) comprend un entraînement qui amène le premier et/ou le deuxième coulisseau (140-1, 140-2 ; 160-1, 160-2) à modifier la distance des sections de coulisseau respectives (142-1, 142-2 ; 162-1, 162-2) par rapport aux outils de réception (132, 152) du dispositif de rotation respectif (130, 150) dans la direction radiale par rapport à l'axe de rotation respectif.

6. Appareil selon l'une quelconque des revendications précédentes, dans lequel chaque coulisseau (140-1, 140-2 ; 160-1, 160-2) a un entraînement dédié qui fait varier une distance de la partie respective du coulisseau (142-1, 142-2 ; 162-1, 162-2) par rapport à une face d'extrémité des outils de saisie respectifs (132, 152) dans la direction d'un axe central longitudinal respectif des outils de saisie (132, 152).

7. Appareil selon l'une quelconque des revendications précédentes, dans lequel les glissières coopérantes (140-1, 140-2 ; 160-1, 160-2) sur le premier et/ou le second dispositif de rotation (130, 150) sont agencées et destinées à se déplacer dans la même direction et de manière au moins approximativement synchrone vers ou depuis la position d'inspection respective.

8. Appareil selon l'une quelconque des revendications précédentes, dans lequel il est prévu une caméra (K1, K2, K3) qui est adaptée pour détecter la distance des parties coulissantes (142-1, 142-2 ; 162-1, 162-2) par rapport à la face d'extrémité respective des outils de réception (132, 152) dans une direction de l'axe central longitudinal respectif des outils de réception (132, 152).

9. Procédé pour aligner et inspecter optiquement un composant semi-conducteur situé sur un outil de prélèvement (132), dans lequel l'outil de prélèvement est disposé sur un premier dispositif de rotation (130) pour le composant semi-conducteur (B), et dans lequel le composant semi-conducteur est aligné par rapport à un centre de l'outil de prélèvement dans au moins une direction d'axe et/ou une direction de rotation, dans lequel le composant semi-conducteur est mis en rotation autour d'un premier axe de rotation et, ce faisant, le composant semi-conducteur est transporté d'une première position de prise en charge à une première position de dépose, et deux premiers dispositifs de rotation (130) pour le composant semi-conducteur (B), qui peuvent être rapprochés et éloignés l'un de l'autre, sont disposés dans l'outil de prise en charge. des glissières (140-1, 140-2) ayant des premières parties de glissière (142-1, 142-2) qui butent contre deux premières surfaces latérales du dispositif à semi-conducteur au moins en partie, de sorte que les deux premières glissières alignent le dispositif à semi-conducteur situé sur l'outil de saisie en faisant glisser et/ou tourner le dispositif à semi-conducteur vers une position d'inspection tandis que l'outil de saisie tient le dispositif à semi-conducteur.

10. Procédé selon la revendication 9, dans lequel une face d'extrémité éloignée de l'outil de saisie et/ou au moins une des deux premières faces latérales du composant semi-conducteur sont inspectées au moyen d'un agencement de caméra qui est aligné avec le premier dispositif de rotation de telle sorte que l'outil de saisie avec le composant semi-conducteur situé sur celui-ci est espacé d'un dispositif optique de l'agencement de caméra et est au moins temporairement aligné avec un axe optique de l'agencement de caméra.

11. Procédé selon la revendication 9 ou 10, dans lequel un deuxième dispositif de rotation tourne autour d'un deuxième axe de rotation et prend ainsi en charge le composant semi-conducteur du premier dispositif de rotation depuis sa première position de dépôt dans une deuxième position de réception du deuxième dispositif de rotation pour transporter le composant semi-conducteur dans une deuxième position de dépôt, dans lequel le premier axe de rotation et le deuxième axe de rotation sont décalés l'un par rapport à l'autre d'un angle d'environ 90°, et dans lequel la première position de dépôt du premier dispositif de rotation est alignée avec la deuxième position de réception du deuxième dispositif de rotation de sorte que le composant semi-conducteur doit être transféré du premierau deuxième dispositif de rotation.

12. Procédé selon l'une quelconque des revendications 9 à 11, dans lequel le second moyen de rotation du dispositif à semi-conducteur pour l'alignement et l'inspection optique est associé à des moyens similaires pour amener le dispositif à semi-conducteur situé sur l'outil de saisie à être aligné en poussant et/ou en tournant le dispositif à semi-conducteur vers une position d'inspection tandis que l'outil de saisie tient le dispositif à semi-conducteur.

13. Procédé selon l'une quelconque des revendications 9 à 12, dans lequel la distance des sections coulissantes respectives par rapport aux outils de réception du dispositif de tournage respectif est modifiée en direction radiale par rapport à l'axe de tournage.

14. Procédé selon l'une quelconque des revendications 9 à 13, dans lequel les coulisseaux coopérants du premier et/ou du second dispositif de rotation se déplacent dans la même direction et de manière au moins approximativement synchrone vers ou depuis la position d'inspection respective.
